# EUROPEAN PATENT APPLICATION

(11) **EP 2 814 137 A1**
(43) Date of publication of application: **17.12.2014**
(21) Application number: 13742951.0
(22) Date of filing: 30.01.2013
(51) Int. Cl.: H02J 17/00

(54) **NON-CONTACT POWER TRANSMITTING SYSTEM**

(30) Priority: 01.02.2012 JP 2012019665
(71) Applicant: Yazaki Corporation, Minato-ku Tokyo 108-8333 (JP)
(72) Inventor: TANAKA, Shingo, Yokosuka-shi Kanagawa 237-0061 (JP); NAKAGAWA, Yuta, Yokosuka-shi Kanagawa 237-0061 (JP)
(74) Representative: Grünecker, Kinkeldey, Stockmair & Schwanhäusser
(86) International application number: PCT/JP2013/052033
(87) International publication number: WO 2013/115245

(57) **Abstract**

Disclosed is a non-contact electric power transmission system optimizing an impedance matching and mitigating reduction of transmission efficiency. The non-contact electric power transmission system includes a power feeding unit (3) provided with a power feeding side coil (7) to which electric power is supplied, a power receiving unit (5) provided with a power receiving side coil (9) electromagnetically coupled with the power feeding side coil (7), and a capacitor (8, 11) connected in parallel with at least one of the power feeding side coil (7) and the power receiving side coil (9) so as to compose a resonance circuit, a capacity of which is varied such that a resonance frequency of the resonance circuit when the power feeding side coil (7) and the power receiving side coil (9) are critically coupled in a predetermined coil-to-coil distance between the power feeding side coil and the power receiving side coil, and a resonance frequency of the resonance circuit when the power feeding side coil and the power receiving side coil are over-coupled in a distance shorter than the coil-to-coil distance are conformed.

## Description

### [Technical Field]

This invention relates to non-contact electric power transmission systems.

### [Background Art]

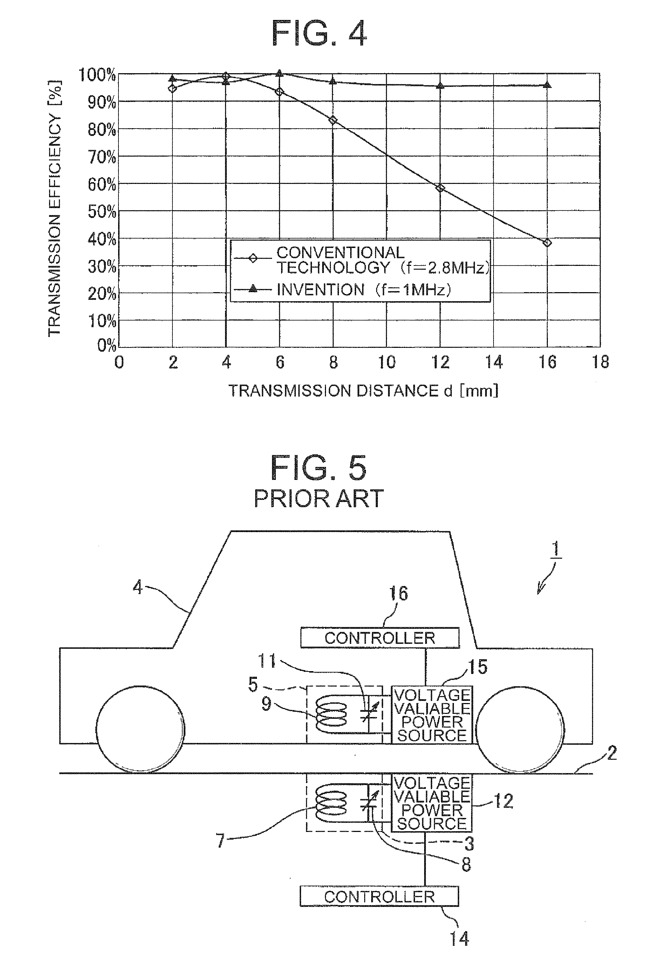

Fig. 5 is a configuration diagram generally illustrating a conventional non-contact electric power transmission system. The non-contact electric power transmission system 1 is provided with a power feeding unit 3 disposed such on a fixed body 2 such as a ground of a car parking space as a feeding unit, a power receiving unit 5 disposed in a body of an automobile 4 as a power receiving unit, a voltage-variable power source 12 which is applied to both ends of a power feeding side varactor 8 (to be mentioned later) of the power feeding unit 3, a controller 14 adjusting and controlling a voltage of the voltage-variable power source 12, a voltage-variable power source 15 which is applied to both ends of a power receiving side varactor 11 (to be mentioned later) of the power receiving unit 5, and a controller 16 adjusting and controlling a voltage of the voltage-variable power source 15.

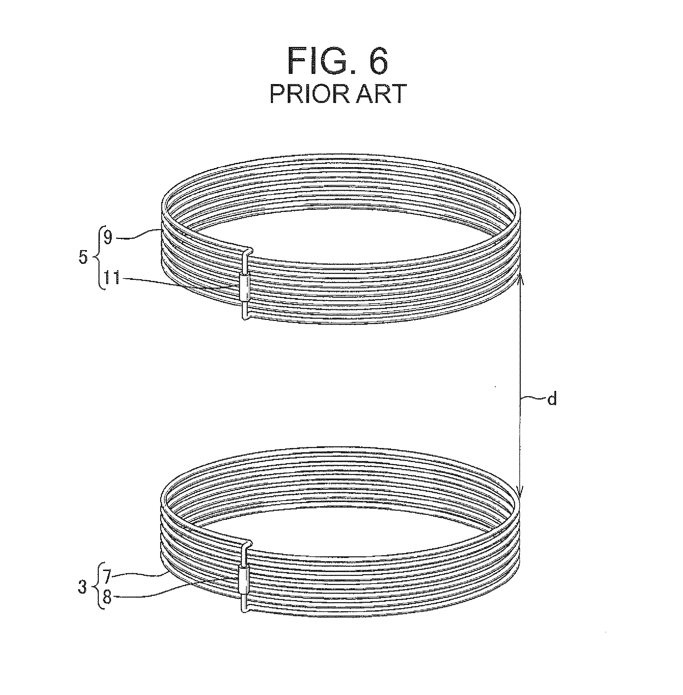

The power feeding unit 3 is provided with a power feeding side coil 7 to which a power is supplied, and the power feeding side varactor 8 connected in parallel to the power feeding side coil 7 as shown in Figs. 5 and 6. The varactor 8 is a diode in which an electrostatic capacity varies according to a voltage that is applied to its both ends.

The power receiving unit 5 is provided with a power receiving side coil 9, and the power receiving side varactor 11 connected in parallel to the power receiving unit 9. The varactor 11 is a diode in which an electrostatic capacity varies according to a voltage that is applied to its both ends.

According to the foregoing non-contact electric power transmission system 1, when the automobile 4 approaches the power feeding unit 3 and the power feeding side coil 7 and the power receiving side coil 9 face each other spaced in an axial direction, the power feeding side coil 7 and the power receiving side coil 9 are coupled by electromagnetical induction so as to supply power from the power feeding unit 3 to the power receiving unit 5 in a non-contact manner.

Namely, to the power feeding side coil 7 a power is supplied that is transformed to a high-frequency power (frequency f (Hz)) from a direct current power of a direct current power source (not shown). This is because the direct current can not travel in the space. The high-frequency power is transmitted from the power feeding side coil 7 to the power receiving side coil 9 by freely travelling in the space. The high-frequency power transmitted to the power receiving side coil 9 is transformed to a direct current power by such a rectifier (not shown). The direct current power can be thus transmitted in a non-contact manner from the power feeding side to the power receiving side.

The power feeding side coil 7 and the power receiving side coil 9 are configured in the same fashion. Both ends of the coil are referred to as ports, both ends of the power feeding side coil 7 as power feeding ports, both ends of the power receiving side coil 9 as power receiving ports. The power feeding side varactor 8 and the power receiving side varactor 11 connected in parallel with coils are used for performing a resonance frequency adjustment of a resonance circuit composed of a coil and a capacitance, and an impedance matching in the ports. Also, a ferrite may be used in parallel for improving efficiency at a low frequency, but in Fig. 5 a configuration is shown without the ferrite. Herein, taking as an example that a diameter of the coil being 60 mm, a diameter of copper wire composing the coil 1.2 mm, the number of turns of the coil 5 turns, an impedance of the port 50 Ω, a simulation result (moment method) will be described, but other values may be effective.

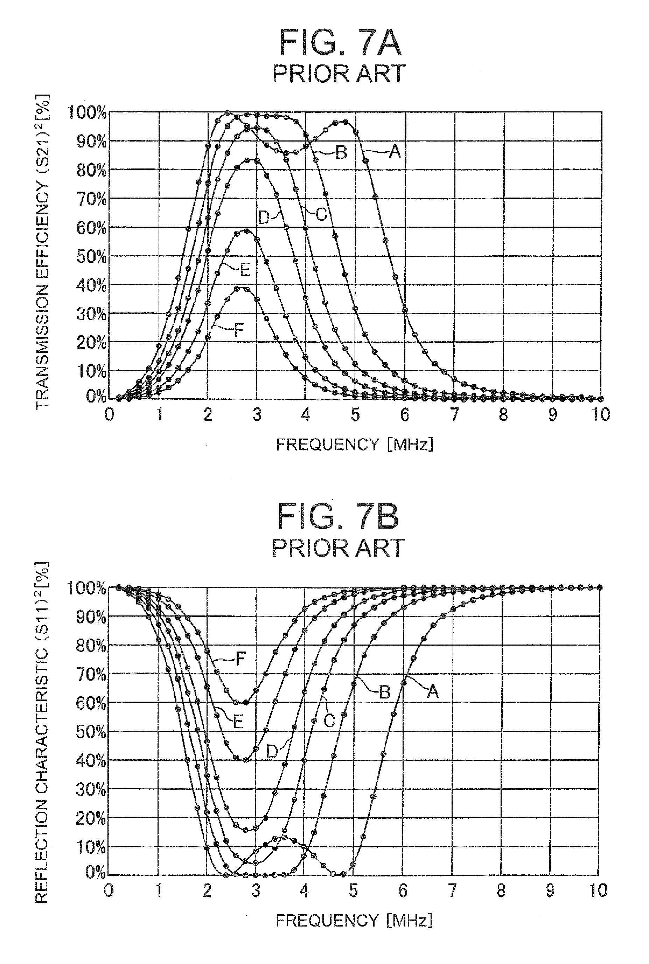

Fig. 7A illustrates a frequency vs transmission efficiency characteristic, and Fig. 7B a frequency vs reflection characteristic, when in the case of a capacity Cp of the power feeding side varactor 8 and the power receiving side varactor 11 being fixed, a distance between the power feeding side coil 7 and the power receiving side coil 9 is varied. In the frequency vs transmission efficiency characteristic of 7A, characteristic curves A-F each show characteristics of transmission efficiencies d2_(S21)², d4_(S21)², d6_(S21)², d8_(S21)², d12_(S21)², and d16_(S21)² in the case of the distances d being 2 mm, 4mm, 6mm, 8 mm, 12 mm, and 16 mm. In the frequency vs reflection characteristic of 7B, characteristic curves A-F also each show characteristics of reflections d2_(S11)², d4_(S11)², d6_(S11)², d8_(S11)², d12_(S11)², and d16_(S11)² in the case of the distances d being 2 mm, 4mm, 6mm, 8 mm, 12 mm, and 16 mm.

In Figs. 7A n 7B, when the coil-to-coil distance d between the power feeding side coil 7 and the power receiving side coil 9 reaches a predetermined value at which the power feeding side coil 7 and the power receiving side coil 9 are critically coupled, the impedance matching is optimized to maximize the transmission efficiency and minimize reflection loss (refer to characteristic curve B). When the coil-to-coil distance d increases over the predetermined value so as to become loose coupling, the impedance matching cannot be achieved and the reflection loss thereby becomes increased (characteristic curves C-F). Also, when the coil-to-coil distance d becomes too narrow so as to become over-coupling, the resonance frequency becomes divided in two and the bandwidth becomes narrow, but in the two resonance frequencies the transmission efficiency and the reflection loss become generally the same as is critical-coupling (characteristic curve A).

In this example, Cp is fixed to 1500 pF (resonance frequency = 2.8 MHz), but at this vale an optimal impedance matching is obtained (no reflation) at d = 4 mm (a predetermined value), and maximum transmission efficiency is obtained (critical-coupling) at d = 4 mm. However, at d > 4 mm the impedance matching is not achieved, and the reflection loss becomes increased, which causes reduction of the transmission efficiency. Adversely, in the case of d < 4 mm, or d = 2 mm for example, over-coupling occurs, and the resonance frequency is divided in two, bandwidth of which becomes narrow. Thus, when Cp is fixed, in the case of the distance varying, reduction of the transmission efficiency is induced in a conventional field.

### [Citation List]

### [Patent Literature]

[PTL 1]
Japanese Patent Application Laid-Open Publication No. 2010-259204

### [Summary of Invention]

### [Technical Problem]

The present invention thus aims at providing a non-contact electric power transmission system allowing for optimizing an impedance matching and for mitigating reduction of a transmission efficiency.

### [Solution to Problem]

An invention according to one aspect for solving the foregoing problems is related to a non-contact electric power transmission system including a power feeding unit 3 provided with a power feeding side coil 7 to which electric power is supplied, a power receiving unit 5 provided with a power receiving side coil 9 electromagnetically coupled with the power feeding side coil 7, and a capacitor 8 (11) connected in parallel with at least one of the power feeding side coil 7 and the power receiving side coil 9 so as to compose a resonance circuit, a capacity of which is varied such that a resonance frequency of the resonance circuit when the power feeding side coil 7 and the power receiving side coil 9 are critically coupled in a predetermined coil-to-coil distance between the power feeding side coil 7 and the power receiving side coil 9, and a resonance frequency of the resonance circuit when the power feeding side coil 7 and the power receiving side coil 9 are over-coupled in a distance shorter than the coil-to-coil distance are conformed.

Preferably, the capacity of the capacitor 8 (11) is varied such that the resonance frequency of the resonance circuit when the power feeding side coil 7 and the power receiving side coil 9 are critically coupled in the predetermined coil-to-coil distance, and a lower resonance frequency of two resonance frequencies when the power feeding side coil 7 and the power receiving side coil 9 are over-coupled to include the two resonance frequencies in a distance shorter than the coil-to-coil distance are conformed.

Preferably, the non-contact electric power transmission system further includes a distance measuring unit 13 measuring the coil-to-coil distance between the power feeding side coil7 and the power receiving side coil 9, and an adjusting unit 14 (16) adjusting the capacity of the capacitor 8 (11) according to the coil-to-coil distance measured by the distance measuring unit 13.

Reference numerals in descriptions, of means for solving the foregoing problems hereinafter correspond to those of elements in descriptions of embodiments for reducing the invention to practice, but is not intended to limit the scope of what is claimed.

### [Advantageous Effects of Invention]

According to the invention of the one aspect, since there is provided the capacitor connected in parallel with at least one of the power feeding side coil and the power receiving side coil so as to compose a resonance circuit, and a capacity of the capacitor is varied such that a resonance frequency of the resonance circuit when the power feeding side coil and the power receiving side coil are critically coupled in a predetermined coil-to-coil distance between the power feeding side coil and the power receiving side coil, and a resonance frequency of the resonance circuit when the power feeding side coil and the power receiving side coil are over-coupled in a distance shorter than the coil-to-coil distance are conformed, even though the distance between the power feeding side coil and the power receiving side coil is varied, varying the capacity of the capacitor in accordance with it allows for optimizing the impedance matching and mitigating reduction of the transmission efficiency.

According to the invention, since the capacity is varied such that the resonance frequency of the resonance circuit when the power feeding side coil and the power receiving side coil are critically coupled in the predetermined coil-to-coil distance, and the lower resonance frequency of two resonance frequencies when the power feeding side coil and the power receiving side coil are over-coupled so as to include the two resonance frequencies in the distance shorter than the coil-to-coil distance are conformed, even though the distance between the power feeding side coil and the power receiving side coil is varied, varying the capacity of the capacitor in accordance with it allows for optimizing the impedance matching and mitigating reduction of the transmission efficiency.

According to the invention, since the distance measuring unit measures the coil-to-coil distance between the power feeding side coil and the power receiving side coil, and the adjusting unit adjusts the capacity of the capacitor according to the coil-to-coil distance measured by the distance measuring unit, even though the distance between the power feeding side coil and the power receiving side coil is varied, it is made possible to adjust the capacity such that the impedance matching is automatically optimized in accordance with it so as to mitigate reduction of the transmission efficiency.

### [Brief Description of Drawings]

[Fig. 1]

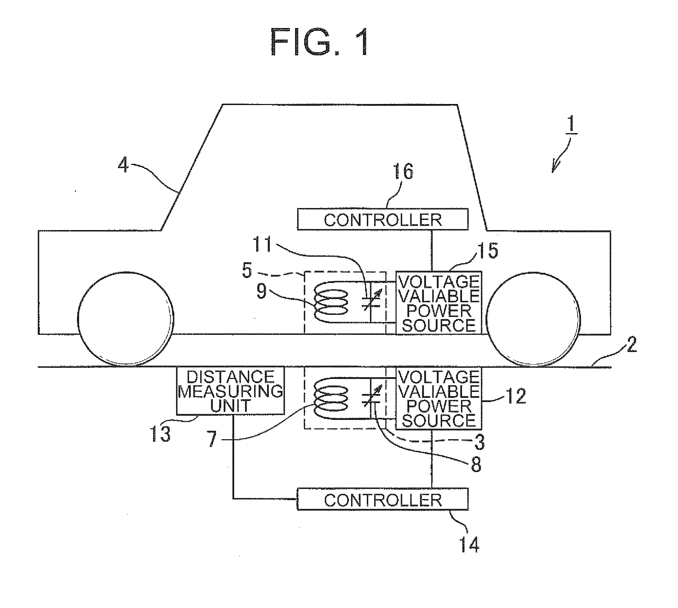

   FIG. 1 is a configuration diagram illustrating one embodiment of a non-contact electric power transmission system according to the invention;
[Fig. 2A]

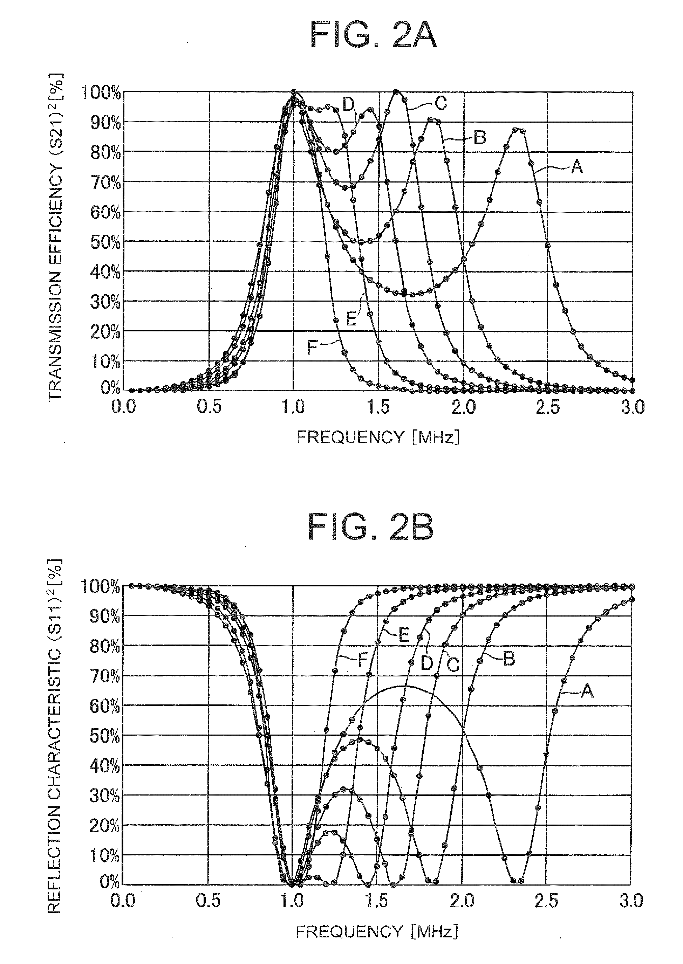

   FIG. 2A is a characteristic chart of a frequency vs transmission efficiency illustrating transmission characteristic when a distance d between a power feeding side coil and a power receiving side coil is varied in a resonance frequency of 1 MHz in the non-contact electric power transmission system according to the invention;
[Fig. 2B]
   FIG. 2B is a characteristic chart of a frequency vs reflection illustrating transmission characteristic when a distance d between a power feeding side coil and a power receiving side coil is varied in a resonance frequency of 1 MHz in the non-contact electric power transmission system according to the invention;
[Fig. 3A]

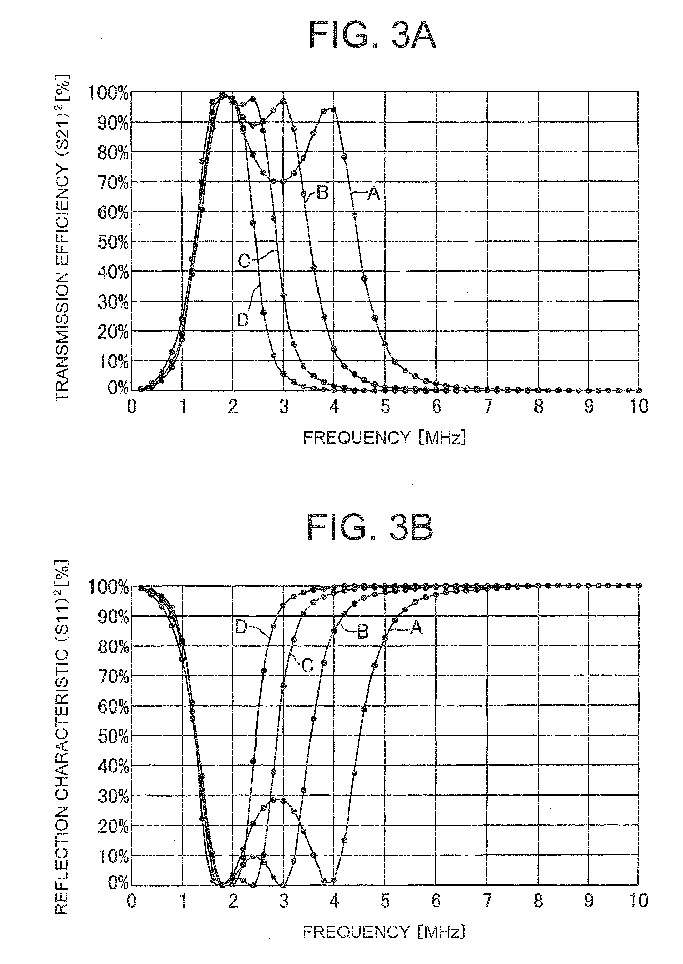

   FIG. 3A is a characteristic chart of a frequency vs transmission efficiency illustrating transmission characteristic when a distance d between a power feeding side coil and a power receiving side coil is varied in a resonance frequency of 1.8 MHz in the non-contact electric power transmission system according to the invention;
[Fig. 3B]
   FIG. 3B is a characteristic chart of a frequency vs transmission efficiency illustrating transmission characteristic when a distance d between a power feeding side coil and a power receiving side coil is varied in a resonance frequency of 1.8 MHz in the non-contact electric power transmission system according to the invention;
[Fig. 4]
   FIG. 4 is a characteristic chart of a transmission distance d (coil-to-coil distance) vs transmission efficiency in a conventional technology and an embodiment;
[Fig. 5]
   FIG. 5 is a configuration diagram illustrating a general configuration of one embodiment of a conventional non-contact electric power transmission system;
[Fig. 6]
   FIG. 6 is a configuration diagram illustrating a configuration of a power feeding unit and a power receiving unit in the non-contact electric power transmission system of Fig. 5;
[Fig. 7A]
   FIG. 7A is a frequency vs transmission efficiency characteristic chart illustrating transmission characteristic when a distance d between a power feeding side coil and a power receiving side coil is varied in the non-contact electric power transmission system of Fig. 5; and
[Fig. 7B]
   FIG. 7B is a frequency vs reflection characteristic chart when a distance d between a power feeding side coil and a power receiving side coil is varied in the non-contact electric power transmission system of Fig. 5.

### [Description of Embodiments]

Hereinafter, with reference to drawings, a non-contact electric power transmission system of the invention will be described. Fig. 1 is a configuration diagram illustrating one embodiment of a non-contact electric power transmission system according to the invention. Note that the same elements as a conventional example shown in Fig. 5 are described noting the same reference numerals.

The non-contact electric power transmission system 1 is provided with a power feeding unit 3 as a power feeding unit disposed on such a fixed body 2, a power receiving unit 5 as a power receiving unit disposed in a body (car bottom) of an automobile 4 that is a mobile body, a voltage-variable power source 12, a distance measuring unit 13, a controller 14, a voltage-variable power source 15, and a controller 16.

The power feeding unit 3 is provided with a power feeding side coil 7 and a power feeding side varactor 8 as shown in Figs. 5 and 6. The power feeding side varactor 8 is a diode, of which electrostatic capacity varies in accordance with a voltage applied to both ends from the voltage-variable power source 12.

The power receiving unit 5 is provided with a power receiving side coil 9 and a power receiving side varactor 11 connected in parallel to the power receiving side coil 9. The power receiving varactor 11 is a diode, of which electrostatic capacity varies in accordance with a voltage applied to both ends from the voltage-variable power source 15.

As the distance measuring unit 13 for example, an electric measuring unit by an infrared signal or radio signal such as an infrared distance sensor or a UWB (ultra wide band) positioning sensor is used, which measures a distance from the fixed body 2 to the automobile 4, from the measured distance a coil-to-coil distance d between the power feeding side coil 7 and the power receiving side coil 9 being obtained. The coil-to-coil distance d may vary in such a fashion that a distance becomes short in accordance with the number of passengers or a mounted package volume varied from a distance in the automobile 4 with no passenger or package (corresponding to "a predetermined coil-to-coil distance" in Claims).

The controller 14 is for example composed of a CPU, which serves as a measuring means controlling the voltage-variable power source 12 such that a voltage according to the coil-to-coil distance d measured by the distance measuring unit 13 is applied to the power feeding side varactor 8.

Then, before an operation of the foregoing non-contact electric power transmission system 1 is described, a basic principle of the invention is described.

The basic principle is as follows: As can be seen from Fig. 7 of the foregoing conventional technology, in the case of the coil-to-coil distance d being varied, when the coil-to-coil distance d increases so as to be loosely-coupling, the impedance matching cannot be achieved, and thereby reflection loss increases. However, when the coil-to-coil distance d is so narrow as to be over-coupling, resonance frequency becomes divided in two and bandwidth becomes narrow, but reflection loss is significantly low in the two resonance frequencies. Then, when adjusting Cp, resonance frequency is adjusted such that a critical-coupling is achieved at a predetermined coil-to-coil distance, and when a distance becomes shorter than the predetermined coil-to-coil distance, the resonance frequency is adjusted using over-coupling, so as to be adjusted to achieve the same resonance frequency as the critical-coupling.

On the basis of the principle above, a transmission characteristic is shown in Figs. 2A, 2B when the distance d between the power feeding side coil 7 and the power receiving side coil 9 is varied at a frequency of high frequency electric power to be transmitted (resonance frequency of the power feeding unit 3 and the power receiving unit 5) of 1 MHz. Fig. 2A illustrates frequency vs transmission efficiency characteristic, Fig. 2B frequency vs reflection characteristics. In the frequency vs transmission efficiency characteristic of Fig. 2A characteristic curves A to F show transmission efficiencies d2_(S21)², d4_(S21)², d6_(S21)², d8_(S21)², d12_(S21)², and d16_(S21)² at d = 2 mm, 4 mm, 6 mm, 8 mm, 12 mm, and 16 mm, respectively. In the frequency vs reflection characteristic of Fig. 2B, characteristic curves A to F show reflection characteristics d2_(S21)², d4_(S21)², d6_(S21)², d8_(S21)², d12_(S21)², and d16_(S21)² at d = 2 mm, 4 mm, 6 mm, 8 mm, 12 mm, and 16 mm, respectively.

As can be seen from Figs. 2A, 2B, in the case of d = 16 mm, at the resonance frequency f0 = 1 MHz the power feeding side coil 7 and the power receiving side coil 9 are critically coupled. Contrarily, in the case of distance d is smaller than 16 mm (2mm, 4mm, 6mm, 8mm, 12mm), the power feeding side coil 7 and the power receiving side coil 9 are over-coupled with two resonance frequencies (f1, f2 (f1 < f2)), and of two resonance frequencies a lower resonance frequency f1 is made to conform with the resonance frequency f0 (1 MHz) of the critical-coupling in the case of d = 16 mm. As a result, within a wide scope of d = 2 mm to 16 mm transmission efficiency reaches over 95% and the resonance frequency f0 is fixed to what is achieved at d = 16 mm (1 MH z) .

Describing specific designing procedure of the invention, firstly, a maximum distance d_max between the power feeding side coil 7 and the power receiving side coil 9 is set (in Figs. 2A, 2B, d_max= 16 mm). The d_max corresponds to "a predetermined coil-to-coil distance" in claims. The resonance frequency f0 in the critical-coupling at this d_max (f0 = 1MHz in the case of Figs. 2A, 2B) is obtained. In d < d_max (over-coupling) adjusting the capacity Cp of the power feeding side varactor 8 and the power receiving side varactor 11 makes the lower frequency f1 in the two resonance frequencies to conform with the resonance frequency f0 in the case of critical-coupling. The power feeding side varactor 8 and the power receiving side varactor 11 are as shown in Table 1 in order to conform with the resonance frequency f1 in the over-coupling which varies in accordance with the coil-to-coil distance d.

**TABLE. 1**

| DISTANCE d | VARACTOR CAPACITY |
|---|---|
| 2mm | 7400pF |
| 4mm | 8300pF |
| 6mm | 8500pF |
| 8mm | 9000pF |
| 12mm | 10000pF |
| 16mm | 12000pF |

Similarly, designing result in the case of d_max = 8 mm is shown in Fig. 3. As a result, within a scope of d = 2 mm to 8 mm the resonance frequency fo = 1.8 MHz in the case of critical-coupling, the maximum transmission efficiency is obtained. In this case the resonance frequency f0 in the case of the critical-coupling in d_max = 8 mm becomes 1.8 MHz, and thus capacity Cp of the power feeding side coil 8 and the power receiving side varactor 11 is shown as Table 2, which is used for adjusting to the resonance frequency f0 = 1.8 MHz in the case of critical-coupling in d = 8 mm.

**TABLE. 2**

| DISTANCE d | VARACTOR CAPACITY |
|---|---|
| 2mm | 2400pF |
| 4mm | 2700pF |
| 6mm | 3300pF |
| 8mm | 3900pF |

Then, operation of the foregoing electric power feeding system 1 is described. Firstly, the controller 14 imports the coil-to-coil distance d obtained by the distance measuring unit 13. For example, the controller 14 has a table preliminarily stored in a not-shown memory, which shows relationship between the coil-to-coil distance d and the capacity Cp of the power feeding side varactor 8 as shown in Figs. 1 and 2. The controller 14 reads the capacity Cp of the power feeding side varactor 8 corresponding to the coil-to-coil distance d imported from the table, and controls the voltage-variable power source 12 such that the capacity of the power feeding side varactor 8 becomes the read value.

Furthermore, the controller 14 multiplies, at the time of transmission of the high frequency electric power, AM, FM, PM or a modulation signal of ASK, FSK, or PSK modulated by information of the coil-to-coil d obtained by the distance measuring unit 13 with the high frequency, and transmits the high frequency electric power signal as a multiple signal from the power feeding unit 3 to the power receiving unit 5. The controller 16 demodulates the modulation signal from the multiplied high frequency electric power signal received at the power receiving unit 5, and imports information of coil-to-coil distance d. The controller 16 has a table stored in a not-shown memory, which shows relationship between the coil-to-coil distance d and the capacity Cp of the power receiving side varactor 11. The controller 16 reads the capacity Cp of the power receiving side varactor 11 corresponding to the coil-to-coil distance d imported from the table, and controls the voltage-variable power source 15 such that the capacity of the power feeding side varactor 11 becomes the read value.

Since the control as mentioned above, even though the distance between the power feeding side coil 7 and the power receiving side coil 9 varies below the predetermined coil-to-coil distance, makes the resonance frequency f1 upon the over-coupling of the resonance circuit composed of the power feeding side coil 7 and the power feeding side varactor 8 and the resonance circuit composed of the power receiving side coil 9 and the power receiving side varavtor 11 conform with the resonance frequency f0 upon the critical-coupling at the predetermined distance, optimizing the impedance matching, which keeps the transmission efficiency the value upon the critical-coupling.

According to the foregoing power feeding system 1, to the power feeding side coils 7 and the power receiving side coil 9 the power feeding side varactor 8 and the power receiving side varactor 11 are connected in parallel, respectively, of which capacity Cp is variable. Since varying the capacity Cp of the power feeding side varactor 8 and the power receiving side varactor 11 varies the transmission efficiency, variation of the capacity Cp of the power feeding side varactor 8 and the power receiving side varactor 11 in accordance with variation of the coil-to-coil distance d between the power feeding side coil 7 and the power receiving side coil 9 allows electric power to be highly efficiently supplied in a non-contact manner, even if the coil-to-coil distance d between the power feeding side coil 7 and the power receiving side coil 9 varies.

Fig. 4 is a characteristic chart comparing the foregoing present invention and the conventional technology in a chat defined by transmission distance d (coil-to-coil distance) as a horizontal axis, and transmission efficiency as a vertical axis. While the conventional technology achieves a maximum transmission efficiency at d = 4 mm, at other than the distances the transmission efficiency is reduced. According to the invention, being controlled such that the resonance frequency f1 upon the over-coupling for variation of the transmission distance (coil-to-coil distance) d conform with f = 1 MHz upon critical-coupling at the predetermined coil-to-coil distance, the transmission efficiency is kept high without variation of the transmission efficiency.

Since the variation of the capacity Cp of the capacitor is electrically achieved using varactor, combination with advantageous control system also allows for real-time following-up for variation of the coil-to-coil distance according to the invention. The scope of the invention lies in measures for misalignment of coil-to-coil distance by variation of the capacity of the capacitor, but is achieved by not only varactor but mechanical variable capacitor such as variable condensor, or what is selectively switched from a plurality of capacities arranged in parallel.

In the invention, using such feed-back control allows for detailed response for the detailed variation of coil-to-coil distance induced by the number of passenger or packs.

As mentioned above, while embodiments of the invention are described, the invention is not limited to this, but allows for various modifications or applications. The variations or applications as far as still including subject matter of the invention lie within the scope of the invention.

For example, while in the foregoing embodiments data of the coil-to-coil distance d measured by the distance measuring unit 13 is transmitted to the automobile 4 side, but the invention is not limited to this. For example, data of the capacity C of the power feeding side varactor 8 according to the foregoing coil-to-coil distance d may be transmitted.

Also, while in the foregoing embodiments distance data is multiplied with the high frequency electric power signal upon electric power transmission, communication with a frequency other than that for electric power transmission allows, instead of the above, for communication of distance data.

While in the foregoing embodiments, to the power feeding side coil 7 and the power receiving side coil 9, the power feeding side varactor 8 and the power receiving side varactor 11 are connected in parallel, respectively, the invention is not limited to this. For example, eliminating the power receiving side varactor 11, only at the power feeding side coil 7 the power feeding side varactor 8 is disposed, the capacity of the power feeding side varactor 8 may be only adjusted. Also, eliminating the power feeding side varactor 8, only at the power receiving side coil 9 the power receiving side varactor 11 is disposed, the capacity of the power receiving side varactor 11 may be adjusted.

Also, as the other embodiments, monitoring reflection loss of a target frequency in each port, the capacity of the capacitor may be controlled such as to minimize the reflection loss.

### [Reference Signs List]

3 power feeding unit (power feeding means)
5 power receiving unit (power receiving means)
7 power feeding side coil
8 power feeding side varactor (capacitor)
9 power receiving side coil
11 power receiving side varactor (capacitor)
12 voltage-variable power source (a part of adjusting means)
13 distance measuring unit (distance measuring means)
14 controller (a part of adjusting means)
15 voltage-variable power source (a part of adjusting means)
16 controller (a part of adjusting means)

## Claims

1. A non-contact electric power transmission system comprising:
a power feeding unit provided with a power feeding side coil to which electric power is supplied;
a power receiving unit provided with a power receiving side coil electromagnetically coupled with the power feeding side coil; and
a capacitor connected in parallel with at least one of the power feeding side coil and the power receiving side coil so as to compose a resonance circuit, a capacity of the capacitor being varied such that a resonance frequency of the resonance circuit when the power feeding side coil and the power receiving side coil are critically coupled in a predetermined coil-to-coil distance between the power feeding side coil and the power receiving side coil, and a resonance frequency of the resonance circuit when the power feeding side coil and the power receiving side coil are over-coupled in a distance shorter than the coil-to-coil distance are conformed.x

2. The non-contact electric power transmission system according to claim 1,
wherein the capacity of the capacitor is varied such that the resonance frequency of the resonance circuit when the power feeding side coil and the power receiving side coil are critically coupled in the predetermined coil-to-coil distance between the power feeding side coil and the power receiving side coil, and a lower resonance frequency of two resonance frequencies when the power feeding side coil and the power receiving side coil are over-coupled to include the two resonance frequencies in a distance shorter than the coil-to-coil distance are conformed.

3. The non-contact electric power transmission system according to claim 1 or 2, further comprising a distance measuring unit measuring the coil-to-coil distance between the power feeding side coil and the power receiving side coil, and an adjusting unit adjusting the capacity of the capacitor according to the coil-to-coil distance measured by the distance measuring unit.
